Europäisches Patentamt

European Patent Office

Office européen des brevets

(11) Publication number: **0 323 191**
**A2**

# EUROPEAN PATENT APPLICATION

(21) Application number: 88312303.6

(22) Date of filing: 23.12.88

(51) Int. Cl.⁴: **G03F 1/00 , G03F 7/26**

(30) Priority: 28.12.87 JP 332808/87
01.11.88 JP 276897/88

(43) Date of publication of application:
**05.07.89 Bulletin 89/27**

(84) Designated Contracting States:
**DE FR GB**

(71) Applicant: **TOYO INK Manufacturing Co., Ltd.
No. 3-13, Kyobashi 2-chome Chuo-ku
Tokyo(JP)**

(72) Inventor: **Ohta, Masaru TOYO INK
MANUFACTURING CO. LTD, 3-13
Kyobashi 2-chome
Chuo-ku Tokyo(JP)**
Inventor: **Sumita, Masujiro TOYO INK
MANUFACTURING CO. LTD.
3-13 Kyobashi 2-chome
Chuo-ku Tokyo(JP)**
Inventor: **Matsuo, Masaaki TOYO INK
MANUFACTURING CO. LTD.
3-13 Kyobashi 2-chome
Chuo-ku Tokyo(JP)**
Inventor: **Hosoi, Isao TOYO INK
MANUFACTURING CO. LTD, 3-13
Kyobashi 2-chome
Chuo-ku Tokyo(JP)**

(74) Representative: **Myerscough, Philip Boyd et al
J.A.Kemp & Co. 14, South Square Gray's Inn
London, WC1R 5EU(GB)**

(54) Image-forming material.

(57) This invention provides an image-forming material suitable for use in an image transfer process which comprises a substrate and a photosensitive layer, optionally having a protective film, the photosensitive layer comprising a dye or pigment and a photopolymerizable compound, wherein the photosensitive layer comprises two or more layers, the dye or pigment being contained in at least one of those layers but being absent from the layer in direct contact with the substrate, the image forming material being such that upon imagewise exposure the exposed areas and unexposed areas differ in their adhesion to a receptor and image transfer occurs through a breakaway separator within the layer in direct contact with the substrate.

## Image-forming material

### FIELD OF THE INVENTION

This invention relates to image formation. More specifically, it relates to an image-forming material usable for image formation by a mono-color or overlaps of multicolors using a difference in adhesion property between an exposed portion and non-exposed portion in light sensitive layer, said image-forming material being capable of giving a transferred matter, similar to a printed matter, for pre-press proof of color printings.

### DESCRIPTION OF PRIOR ARTS

In the field of printing industry, conventionally, it is known to use pre-press proof as means to check, prior to printing, the finish, color tone, etc., of final printed matter. This pre-press proof is carried out by overlay method or surprint method, and these methods are used depending upon purposes in checking of final image qualities and steps of plate making and printing.

In the overlay method, each of transparent base films is provided with a light sensitive layer for a separate color to form a final image, and the films obtained by carrying out active beam irradiation and development steps are overlaid one on another with registering the images of separate colors by the eyes, etc. This method is very simple. However, it has defects that an image obtained by this method is affected by reflected lights from overlaid films and differs from the texture of an actual final printed matter to a great extent.

In the surprint method, as disclosed, e.g., in U.S. Patents 3,060,023, 3,060,024, and 3,060,025, several light sensitive layers are contacted onto a single substrate one after another to progressively form an image by separate colors. For coloring, there is a method of simple transferring or using powder color toners. The transfer method has an advantage of being simple in operation. Meanwhile, the method of using powder color toners makes it necessary to consider operational environments due to scatter of the powder. The quality of a duplicate for the pre-press proof is required to be very similar to that of a printed matter. However, it can hardly be said that a duplicate obtained by transfer is similar to a printed matter in glossiness, dot reproducibility, etc. And in the method using powder color toners, due to its operation quite dissimilar to an actual printing operation, it is difficult to make the resulting duplicate similar to an actual printed matter.

Further, U.S. Patent 3,060,023 discloses a transfer method in which a light sensitive layer and an image receptor are flatly contacted to each other under pressure, heated and then separated. However, said method has disadvantage of lacking stable image reproduction and rapidness required of pre-press proof. It also has a defect in operation that adjustment of a speed, direction and strength for the separation after the contact under pressure is difficult. Namely, when a light sensitive layer and an image receptor are separated after the flat contact under pressure, a picking easily takes place if the operational conditions are not rigidly adjusted. Further, even if conditions are set so as not to cause the picking, it is difficult to control the conditions of speed, direction, etc. for the separation. Therefore, the reproduction of transferred images is rendered unstable, nonuniformity of reflection density of a transferred image and minute periodic patterns are caused, and further minute directionally repetitive patterns are caused; Accuracy in color reproduction or the like is reduced to a great extent.

Japanese Laid-Open Patent Publications 97140/84 and 188537/86 disclose a proofing system usable both in the overlay method and surprint method. In this proofing system;

(1) A color sheet is prepared by consecutively laminating a release layer, a coloring photosensitive layer and a protection layer on a polyester substrate; and an image receptor film is prepared by laminating an image receptor layer and a protection layer on a polyester substrate;

(2) The photosensitive layer of the color sheet and a half-tone negative are intimately contacted and exposed to form an image, and a non-exposed portion is eluted with a sodium carbonate/butylcellosolve/water mixture liquid. The obtained image after dried is effective also for overlay type proofing;

(3) For proofing in the surprint system, the image of black formed on the above color sheet is transferred to an image receptor at a temperature of 110 °C, under a pressure of 2 bars and at a speed of 60 cm/minute and then, the receptor film is registered by the eyes or punching, and an image of cyan is transferred in the same procedure as in the image of black. The same procedure is repeated also with regard to magenta and yellow.

(4) Then, the obtained color image is transferred to a receptor to obtain a normal image, and thereafter, the receptor is covered with a film which has been subjected to matting treatment to reduce reflection gloss of a transfer layer and coloring layer, to obtain a proofing sheet.

The above system has defects that it is not always easy to give a texture similar to a printed matter and that a developing step is necessary. Further, an image obtained by one transfer is reverse to that of a printed matter and another transfer step is necessary to obtain a normal image.

There have been a defect that the transfer has to be repeated twice since an image obtained by one transfer is reverse or that even if a normal image is obtained by one transfer, the accuracy in the resultant image is low, i.e., the resultant image lacks sharpness.

Studies have been made on various proofing methods as mentioned above. Meanwhile, with regard to methods of transfer, flat transfer and transfer using a letterpress proof printing machine are known. An image-forming material requireing no developing step is useful in terms of operation, and it is therefore desirable. And there is an advantage that an apparatus for an image formation using such an image-forming material can be simple. However, the conventional image-forming materials have disadvantages that the density and glossiness of the resultant images are different from those of the finally printed image and their finish qualities are insufficient. In any of the methods for preparing a pre-press proof, the resultant image has a textrue dissimlar to that of an image printed by an actual printing machine. Therefore, such methods are mainly and merely used to check steps from plate-making to printing. Even if images obtained by such methods are used as substitute for a printed matter, there has been a compromise in which such images differ in quality.

In an image-forming material having a substrate-coloring photosensitive layer-protection film structure, a separation for transfer occurs somewhere along the thickness of the coloring photosensitive layer when an exposure is effected from the substrate side, the protection film is removed and then the transfer is effected by a breakaway of the photo-sensitive layer in order to obtain a nomral image by one transfer. Therefore, defects are caused that the thickness of the transferred portion is likely to be small, that the resultant density is not sufficient, that the density is not constant even when image-forming materials of the same type are used and the like. When the thickness of the coloring photosensitive layer is increased in order to overcome the above defects, the photopolymerization of that portion of the photosensitive layer which is near to the interface between the photosensitive layer and the protection film becomes insufficient. As the result, an image portion including a non-image portion is transferred to cause a contamination.

Practically, to increase the exposure volume results in inability to speed up the image formation. When the exposure volume is not sufficiently increased, a contaimination occurs in a transferred matter because of insufficient hardening of the photosensitive layer resulting from insufficient exposure.

SUMMARY OF THE INVENTION

It is an object of this invention to provide an image-forming material capable of forming an image having an image quality equal to that obtained by a printing machine.

It is another object of this invention to provide an image-forming material which is excellent in reproducibility of a transferred image and gives a uniform reflection density to a transferred image and which gives a transferred image free from periodic patterns and minute directional patterns.

It is another object of this invention to provide an image-forming material excellent in color reproducibility.

It is another object of this invention to provide an image-forming material suitable for use in surprint method.

It is another object of this invention to provide an image-forming material capable of giving a transferred image free from a contamination of nonprinting area, which is caused by presence of coloring photosensitive layer in the nonprinting area.

It is another object of this invention to provide an image-forming material giving, without using a second transfer step, a transferred image having the same direction as that of a printed image or an original image.

It is further another object of this invention to provide an image-forming material which does not cause a picking when the image-forming material and an image receptor paper are separated.

This invention provides an image-forming material usable for an image transfer which comprises carrying out an image exposure of the image-forming material comprised of a substrate and a photosensitive layer formed on the substrate and containing dye and/or pigment and a photopolymerizable compound to cause a difference in adhesion property between exposed portion and nonexposed portion, and transferring an image to an image receptor on the basis of said difference in adhesion property, said photosensitive layer being comprised of a plurality of layers, the dye and/or pigment being contained in at least one of the layers of the photosensitive layer except one contacting the substrate, the dye and/or pigment being or not being contained in the layers of the photosensitive layer other than the former one containing the dye and/or pigment, the image being transferred to the image receptor by a breakaway separation within the layer contacting the substrate.

## DETAILED DESCRIPTION OF THE INVENTION

This invention provides an image-forming material usable for the surprint method to form a color proof having a texture equivalent to that of an actually printed image simply, speedily and stably. The image-forming material of this invention can also be applied to the overlay method. That is, this invention provides an image-forming material which can give an image having a texture equivalent to that of an image printed by a printing machine and which can give a stable color proof by a developing liquid-free dry development method, i.e., development method by separation.

The image-forming material of this invention makes the resultant image free from a mottling (minute periodic patterns, minute directional patterns, or the like) in image-forming material caused by heating for the transfer, permits an image to be transferred directly to a receptor for a printing machine such as an art paper, etc., and further makes it possible to give a duplicate very similar to a usual printed matter since a photosensitive layer is transferred in the same way as in printing by a printing machine. And a fine image can be also transferred stably by the image-forming material of this invention.

The image-forming material of this invention has a structure consisting of a substrate, a plurality of photosensitive layers containing a coloring photosensitive layer and a protection film. Explanations thereof will be given hereinbelow.

Preferably used as the substrate are materials which are stable to heat, chemicals, light, etc., and through which active beam erradiation light is permeable. For examples, films or sheets made of cellulose acetate, polystyrene, polyvinyl chloride, polyethylene terephthalate, polycarbonate, polyimide, polypropylene, and the like are preferably used. A polyethylene terephthalate film or sheet is especially preferable from the aspects of transparency, thermal stability and dimensional stability.

The above substrates may be used directly, and may be subjected to separating treatment with a suitable oil-repellant substance. A silicon resin, fluorine resin, etc., can be cited as examples of such a oil-repellant substance.

Examples of the protection film include a polyethylene film, polypropylene film, polyethylene terephthalate film, acetate film, etc. However, the protection film shall not be limited to these films. In addition, the protection film in the present application stands for a film which is removed or peeled off after the image exposure, and therefore it is not existent when the transfer is carried out. The substrate is however existent.

The photosensitive layer of this invention comprises two or more layers, and at least one layer next to one contacting the substrate layer contains dye and/or pigment (which may be referred to as a coloring agent hereinbelow). All the layers' forming the photosensitive layer may contain a coloring agent. The separation by breakaway takes place within the layer contacting the substrate.

The photosensitive layer has a constitution of:

(a) a photopolymerizable compound and a coloring agent (the coloring agent may not be contained depending upon conditions), or

(b) a photopolymerizable compound, a thermoplastic resin and a coloring agent.

Usually, however, a photopolymerization initiator, a thermal polymerization inhibitor and/or the like may further be used in combination.

Usable as the photopolymerizable compound is at least one selected from monomer, oligomer and prepolymer.

Further, other additives may be also used.

No special limitation is imposed on the photopolymerizable compound. However, preferably usable is a compound which can plasticize the thermoplastic resin at ordinary temperature.

A photopolymerizable compound is used as the photosensitive layer such that a mixture thereof with dye and/or pigment is curable by exposure.

The photosensitive layer is formed on the substrate, and further, the protection film (cover sheet) is formed on the photosensitive layer. The protection film works to prevent the photosensitive layer from being damaged with an exposure device when the exposure for an image formation is effected from the substrate side. For this purpose, a polyethylene film is preferably usable. Other films having the same performance as that of the polyethylene film may be also used.

That layer of the photosensitive layer which is contacting the substrate undergoes a breakaway separation within itself at the time of transfer. That is, since the photosensitive layer is photopolymerizable, an non-image portion which is cured by the exposure loses its adhesive strength. An image portion of that layer of the photosensitive layer which is next to the substrate is not exposed and therefore has a cohesive strength of a suitable degree. Due to the cohesive strength, the breakaway separation takes place within the above layer contacting the substrate when an image is transferred and the substrate is separated. Accordingly, the image portions of all the layers of the photosensitive layer except the above layer contacting the substrate are all transferred. For this reason, it is made possible to achieve a uniformity in density of a transferred image and accuracy in reproduction of an image.

The internatl cohesive strength of that layer of the photosensitive layer which contacts the substrate is suitably selected from photopolymerizable compound, dyes or pigments, depending upon their kinds and amounts in use. The above internal cohesive strength depends upon the other layer(s) of the photosensitive layer, image receptor or substrate in use.

In order to permit the breakaway separation to occur within that layer of the photosensitive layer which is positioned nearest to the substrate, it is preferable to utilize differences in softening points among the layers forming the photosensitive layer, although any limitation shall not be imposed thereon. For example, the softening points are set at 70°C and 90°C, the breakaway separation takes place within a layer having a softening point of 70°C under appropriate heating conditions.

The color proofing of a printed matter, to which this invention is directed to, requires high accuracy in reproduction of an iamge from an original film, etc., and a shortening of a color proofing time is also required. In order to satisfy these requirements and secure a stable finish quality, the main technical factor in the case of high accuracy in reproduction of an image is to decrease the film thickness of an image to be formed, and the main technical factor in the case of shortening of the color proofing time is to obviate a step to develop an iamge to be formed.

In order to achieve the above requirements and technical factors, the optimal solution is to omit the development step by imparting a suitable internal cohesive strength to a photosensitive layer contacting the substrate, since the internal cohesive strength for the breakway transfer along the thickness of the transfer image film in formation of an image acts to form an image as soon as the exposure is effected.

The photopolymerizable compound usable in this invention is an ethylenically unsaturated compound, and examples of said compound include low-molecular-weight photopolymerizable compounds such as (meth)acrylic acid, methyl(meth)acrylate, butyl(meth)acrylate, cyclohexyl(meth)acrylate, dimethylaminoethyl-(meth)acrylate, benzyl(meth)acrylate, carbitol(meth)acrylate, 2-ethylhexyl(meth)acrylate, lauryl(meth)acrylate, 2-hydroxyethyl(meth)acrylate, 2-hydroxypropyl(meth)acrylate, glycidyl(meth)acrylate, (meth)acrylamide, N-methylol(meth)acrylamide, styrene, acrylonitrile, N-vinyl pyrolidone, ethyleneglycoldiacrylate, diethleneglycoldiacrylate, triethyleneglycoldiacrylate, polyethyleneglycoldi(meth)acrylate, polypropyleneglycoldi-(meth)acrylate, butyleneglycoldi(meth)acrylate, neopentylglycoldi(meth)acrylate, 1,4-butanedioldiacrylate, 1,6-hexanedioldi(meth)acrylate, pentaerythritoldiacrylate, pentaerythritoldiacrylate, pentaerythritoltriacrylate, trimethylolpropanetriacrylate, dipentaerythritolhexaacrylate, phenoxyethylacrylate, nonylphenoxyacrylate, tetrahydrofurfuryloxyacrylate, caprolactone-modified tetrahydrofurfurylacrylate, ethylene oxide (EO)-modified methacrylate, phenoxydiethyleneglycolacrylate, EO-modified phthalic acid acrylate, (meth)acrylate of alkylen oxide-added phenol, caprolactone-modified hydroxypivalic acid neopentylglycoldiacrylate, dicyclopentanyldiacrylate, etc., or high-molecular-weight photopolymerizable compounds such as epoxyacrylate, urethane acrylate, polyester acrylate, alkyd acrylate, modified acrylate of petroleum resin, etc. These compounds may be used alone or in combination.

The thermoplastic resin (organic polymer binder) usable is a polymer which is thermoplastic, excellent in compatibility with the photopolymerizalbe compound and without photopolymerization property. Examples of this resin include polyvinyl chloride, poly(meth)acrylic acid, poly(meth)acrylic acid ester, polyvinyl ether, polyvinyl acetal, urethane resin, epoxy resin, polyamide, polyester, vinylidene chloride-acrylonitrile copolymer, vinylidene chloride-vinyl acetate copolymer, ethylene-vinyl acetate copolymer, cellulose derivative (e.g., methylcellulose, ethylcellulose and cellulose acetate), polyolefin (e.g., chlorinated polyethylene), synthetic rubber such as butadieneacrylonitrile copolymer, diallylphthalate resin (e.g., diallylisophthalate polymer, diallylorthophthalate polymer and hydrogen-addition product of these), etc.

It is also possible to obtain the desired physical property by adding a polymer other than the above thermoplastic substances. For example, adhesion to a substrate, adhesion to a receptor at the time of the transfer can be improved. Examples of suitable polymer substance that is not thermoplastic include phenol resin, malamineformaldehyde resin, urethane resin, etc. Beside these, the photosensitive layer may contain, as a component, a small amount of a filler, examples of which include silica, mica, bentonite, etc., and a suitable amount of the filler may be present depending upon a quality required.

The photopolymerization initiator having small absorption in the visible ray portion is preferable as such. Examples of the initiator include benzophenone, 4,4'-bis (diethylamino) benzophenone, 4-methoxy-4-dimethylaminobenzophenone, 2-ethyl anthraquinone, phenanthraquinone, benzoin, benzoinethyl ether, benzoinphenyl ether, isobutylbenzoin ether, benzoinethyl ether, isobutylbenzoin ether, isopropylbenzoin ether, benzoinethyl ether, 2,2-diethoxyacetophenone, 2-hydroxy-2-methylpropiophenone, 4'-isopropyl-2-hydroxy-2-methylpropiophenone, p-tert. butyltrichloroacetophenone, Michler's ketone, benzyldimethylketal, 2,2-dimethoxy-2-phenylacetophenone, hydroxycyclohexylphenyl ketone, benzophenone, azobisisobutylnitrile, 2-chlorothioxanthone, 2-methylthioxanthone, 2-ethylthioxanthone, 2-isopropylthioxanthone, etc. These photopolymerization initiators may be used alone or in combination. When two or more initiators are used, a mututal influence on free radicals to be generated therefrom respectively by light absorption should be taken into consideration. Further, various sensitizers may be added in order to improve the rate of the photopolymerization. Conventionally known photopolymerization initiators may be used alone or in combination. The proportion of the photopolymerization initiator to be added is 0.1 to 50% by weight, preferably 1 to 10% by weight based on the total weight of the photopolymerizable compound.

As thermal polymerization inhibitor, there may be used p-methoxyphenol, hydroquinone, t-butylcatechol, pyrogallol, pyridine, allylphosphite, and the like. The thermal polymerization inhibitor is added after the physical property of the resultant product, and in general, the proportion of said initiator is 0.001 to 0.1% by weight based on the total weight of the photopolymerizable compound.

Wax, antistatic additive and other additives may be incorporated into the photosensitive layer as required.

The film thickness of the photosensitive layer (total thickness of all the layers forming the photosensitive layer) may be about 0.5 to 5 µm. The suitable amount of the photopolymerizable compound to be applied varies according to dye and/or pigment to be contained. However, the suitable amount is from 0.5 g/m² to 10 g/m² on the basis of dried layer. In this invention, the application of the photosensitive layer to a substrate is carried out by the use of a bar coater and a spin coater, and the other coaters similar thereto may be also used.

As thermoplastic substance effective especially in this invention, the other materials than the above-mentioned ones can also be cited. However, in view of the suitable combination with an ethylenically unsaturated compound, polyacrylate-type high-molecular-weight substance and diallylisophthalate polymer are suitable. The suitable proportion of the thermoplastic substance to ethylenically unsaturated compound varies depending upon what materials are used as such. In general, if the proportion of the thermoplastic substance to ethylenically unsaturated compound is between 40 : 60 and 90 : 10, it is possible to achieve a state in which the surface of the photosensitive layer has no sticking property or adhesion property. If there is a residual adhesion in the photosensitive layer, the registration is rendered difficult, and further, environmental dust, etc., are adhered onto the surface of the photosensitive layer to degrade the quality of an image as color proof. A small amount of a thermal polymerization inhibitor may further be added to prevent a dark reaction from taking place with the passage of time.

As dye and/or pigment to be contained in the photosensitive layer, conventionally known dye and pigment may be used. Dye and/or pigment having a hue identical to these of four colors, yellow, magenta, cyan and black are usually necessary, and in addition, white pigment, fluorescent pigment, etc., may also be used. As for color proof for which yellow, magenta, cyan and black are used, any pigment or dye agreeing with the hues thereof may be selected.

When the coloring agent(s) is contained in a plurality of layers forming the photosensitive layer, there are cases in which all the layers contain coloring agents of the same kind in a same or different concentration, the layers contain different coloring agents, one layer contains a coloring agent while the rest contain no coloring agent, and the like. In addition, when the layer next to the substrate layer contains a coloring agent, it is preferable to lower the concentration of the coloring agent in the layer next to the substrate than that in the layer formed on the former layer. The layer nearest to the protection film may be prepared to be excellently adhering such that the transfer can be effected to a receptor having as rough a surface as a paper of newspaper has.

When different coloring agents are used and one of them is black, the other coloring agents have no

6

special limitation, and may be yellow, magenta, cyan or other black. When one layer contains a coloring agent and the remaining layers contain no coloring agent, it is desirable to use a transparent layer as a layer nearest to the image exposure side, i.e., a layer containing no coloring agent. This procedure is effective in that the shielding of UV ray, etc., can be reduced as much as possible.

The layer(s) containing no coloring agent may have a film thickness of about 0.1 to 3$\mu$m.

The following are some examples of the dye and organic pigment of azo type, phthalocyanine type, quinacridon type, anthraquinone type, cyan type, methine type, etc., or inorganic pigments etc., that is, Lionol Yellow GRO (C. 121090), No. 1201 Lionol Yellow, No.1206 Lionol Yellow, Lionol Yellow No. 1208, No.1305 Lionol Yellow (C. 121100), No.1306 Lionol Yellow, No,1307 Lionol Yellow, Lionol Yellow FG1310, Lionol Yellow FGN-T (C. 121105), No.7100 Lionol Yellow (C. 121096), Lionol Yellow-NBR (C. 121108), Brilliant Carmine 6BA (C. 115850 : 1), Lionol Red 6B4201, Lionol Red 7B4401, Brilliant Carmine 8BA, Lionol Blue FG7330 (C. 174160), Lionol Blue FG7351, Lionol Blue GX-1 (the above items are all manufactured by Toyo Ink Manufacturing Co., Ltd.), Mitsubishi Carbon Black MA-7, Mitsubishi Carbon Black MA-100, etc. These items are suitably used. As. colorant, these items may be used alone or in combination with another.

These dyes and pigments can be easily incorporated into the photosensitive layer through suitable means.

The suitable amount of the dye and/or pigment incorporated into that layer of the photosensitve layer which contacts the substrate 0 to 10 % by weight based on the entire solids. The suitable amount of the dye and/or pigment incorporated into layer(s) of the photosensitive layer other than the above layer which contacts with the substrate is 5 to 50 % by weight based on the weight of the entire solids. If it is not more than 5 % by weight, an extremely large amount of a coating (film) is required to obtain a necessary color density, and a transferred image therefore tends to be bad. If it is not less than 50 % by weight, sufficient active beam does not permeate and a stain is caused. The photosensitive layer is applied so as to be 0.5 g/m$^2$ to 10 g/m$^2$, preferably 1 g/m$^2$ to 5 g/m$^2$, after dried.

The image exposure to light is carried out by two methods; one is an exposure by, in general, direct contact of the photosensitive layer to a mask after removal of the protection film, and the other is an exposure from the substrate side. In the method of exposure of an image to light by direct contact of the photosensitive layer to a mask, the amount of the photo sensitive layer film may be more than 10 g/m$^2$. However, the resulting image faces reversely, and an image including characters or letters is very difficult to observe. The method by placing a mask on the protection film and carrying our the exposure is not desirable in terms of accurate formation of a transferred image, since light diffusion takes place due to the protection film. Further, the image obtained in this case is undesirably reverse.

Further, when the image-forming material is electrically insulating, adsorption of dust occurrs due to static electricity and quality degradation of a transferred image is consequently caused. The electrically insulating image-forming material is not desirable in terms of operationability and safety. Therefore, it is also effective to imaprt electrical conductivity to the image-forming material. To impart electrical conductivity, a plastic film forming the substrate may contain an electrically conductive substance, the substrate may be provided with an electrically conductive layer, the photosensitive layer may contain an electrically conductive substance, and some other method may be used. In view of the exposure, a transparency-retaining substance is suitably used as the electrically conductive substance, and various surface active agents may be used. When the substrate (plastic film) is imparted with electrical conductivity, a surface electrical resistance of not more than 10$^{10}\Omega$ is desirable.

In addition, suitable matting treatment of the photosensitive layer is effective to obtain a good texture as required.

On the other hand, when the image exposure is carried out from the substrate side, the resulting image becomes normal. However, if the amount of photosensitive layer film is more than 10 g/m$^2$, the transferred image tends to be unclear.

Further, the protection film is laid on the photosensitive layer. As described in Japanese Laid-Open Patent Publication No. 31323/73, a polyethylene film is preferable as the protection film since it has a weaker adhesion to the photosensitive layer than a base substrate of a polyethylene terephthalate film. And in a photopolymerization system, it is known that the polymerization rate varies depending upon oxygen in the air. This variation is prevented by forming a coating film of a polyvinyl alcohol on the photosensitive layer or laminating a protection film thereon. These two means are both effective. However, when the formed coating film has a thickness of not less than 5$\mu$, an transferred image quality is adversely affected. Therefore, in the present invention, the laminated protection film is more preferable.

In this invention, when the image exposure is carried out by using a positive film, an image-forming method by exposing an image from the substrate (transparent in nearly all the cases) side is preferable. This method makes it possible to improve the positional relation of an image such as a direction in which an image faces, etc., i.e., there is provided a method which obviates the need of a special intermediate image receptor to correct the facing direction of an image. However, when the exposure is carried out by using a UV ray laser, a normal image can be easily obtained by signal treatment even if the exposure is carried out from the protection film side. In this case, the use of that transparent layer(s) of the photosensitive layer, which is easily curable by a beam from a laser having a small output, next to the protection film is effective to work the present invention.

In this invention, when an image-forming material having a protection film is used, the transparent substrate means one which is contacted to an image receptor under pressure and then separated, and it is preferable to carry out the image exposure from this transparent substrate side.

The protection film optionally used prevents a gleasing caused by adhesion of photosensitive layer to an exposure device, etc., when the image exposure is effected from the substrate side, and it reduces an influence of oxygen on the photosensitive layer.

Color proof work etc., to which this invention is applied, requires high-accuracy reproduction of an image from an original film, etc. At the same time, it is required to shorten a time in color proof work. In order to meet these requirements and secure the stable finish quality, it is desirable to carry out the exposure from the transparent substrate side.

The following is an explanation of the steps for the image formation when the image-forming material of this invention is used, for example, as an image-forming material for color proofing.

(1) Holes for register pins are made in a color separation image mask and an image-forming material. Further, if the image receptor is a paper, etc., the image receptor is also holed for the register pins.

(2) An image exposure is carried out. That is, the photosensitive layer is exposed to light sufficient to harden the image-forming material from the substrate side by the use of an active ray such as ultra violet ray through an image of the color separation mask.

(3) Then, the protection film on the image-forming material is detached, the image receptor and the surface of the photosensitive layer are positioned such that these two members face each other, and the transfer is carried out under pressure or under heat.

(4) The substrate is separated by holding one end thereof so that one third or an appropriate portion, along the thickness, of that layer of the photosensitive layer which is next to the substrate is retained on the substrate by the predetermined internal cohesive strength, and a transferred image is consequently formed on the image receptor.

(5) A post-exposure is carried out for the purpose of firmly securing the adhesion of the entire portions of the transferred image to the receptor and removing the adhesion property of the surface of the transferred image.

The above steps (1) to (5) are repeated, for example, 4 times (yellow, magenta, cyan, black) to obtain a reproduced image of the four colors for color proofing.

As examples of the above image receptor, there are art papers, coat papers, etc., which are materials generally used in proof printing. However, these examples shall not limit this invention.

In the above step (3), it is possible in this invention to carry out the contact flatly under pressure. However, it is preferable to carry out the transfer between rolls or by using a flat-bed printing machine. In these transferring procedures, the contact between the image receptor and the image-forming material, the transfer of an image to the image receptor and the separation of the substrate can be carried out speedily and stably. Further, when the transfer is carried out under heat, the nonuniformity of temperature is also small as compared with the case of the flat contact under pressure.

The transfer is carried out usually under pressure and heat. However, the transfer may be carried out only under pressure. When heating, it is preferable to carry out the heating to an extent that an image receptor used does not expand or shrink much. It brings desirable effects on the transfer rate and the reproduction accuracy of a fine image to carry out the heating such that the surface temperatures of the rolls become 50 to 150 °C, preferably 60 to 100 °C. That is, the good transfer can be done without crawling, picking, etc.

Further, a thermal difference may be provided between the surface of one roll and the surface of the other. For example, one roll may be heated and the other roll may be cooled.

In the image transfer in the present invention, the transfer and the separation may be carried out by using conventional devices such as a laminator.

According to the present invention, there is provided an image-forming material which obviates the heating treatment before the transfer and the control of complicate development work and which can reproduce an image having a very similar texture to that of a printed matter on an image receptor such as a paper.

According to the present invention, there is provided an image-forming material which can give an image of multicolors (as a result of overlaying images of individual colors) which has a stable color density, tranfer uniformity and a quality very similar to a printed image. For example, when a plurality of multicolored images are obtained from one original image, it is possible to obtain a constant finish quality and constant density.

The following Examples illustrate this invention. "part" stands for "part by weight" and "%" stands for "% by weight" hereinbelow.

## EXAMPLE 1

[Photosensitive layer containing coloring agent]

A liquid for a photosensitive layer having the following formulation was prepared.
Diallylisophthalate prepolymer(Daiso Isodap, MW = 45,000, Osaka Soda Co., Ltd.,): 21.23 parts
Dipentaerythritolhexaacrylate DPHA (Nippon Kayaku K.K): 7.08 parts
Photopolymerization initiator, benzophenone: 0.5 part
4,4' bis-diethylaminobenzophenone (EAB, Hodogaya Chemical Co., Ltd.): 0.17 part
Hydroquinone: 0.001 part
Carbon black (MA-7, Mitsubishi Chemical Ind.): 5.0 parts
Toluene: 38.0 parts
Methylethylketone: 40.0 parts

In addition, in place of the above carbon black as a pigment, Lionol Yellow FG1310 for yellow, Lionol Red 7BFG4412 for magenta and Lionol Blue FG7330 for cyan (all manufactured by Toyo Ink Manufacturing Co., Ltd.) were respectively used to prepare liquids for photosensitive layers for yellow, magenta and cyan. The ratios of the above pigments used in the photosensitivelayers were 18% for yellow, 18% for magenta and 18% for cyan.

The above liquids for photosensitive layers were coated on polyethylene films, protection films, having a film thickness of 40 μm by using a bar coater, and the coated polyethylene film were dried by subjecting them to irradiation under an infrared lamp (3 kw) for 30 seconds to prepare positive-type photosensitive layers. The resultant photosensitive layers had a dried coating thickness of 2 μm.

[Photosensitive layer containing no coloring agent]

A liquid for a photosensitive layer having the following formulation was prepared.
Hydrogenated rosin-modified eponester [resin having a softening point of 70 to 73°C and a molecular weight of 7,060, obtained by esterification of Epicoat 1004 (epoxy resin manufactured by Yuka-Shell Epoxy K.K.) with oleic acid and hydrogenated rosin]: 1.6 parts
Ditrimethylolpropanetetraacrylate: 0.4 part
Benzophenone: 0.07 part
4,4' bis-diethylaminobenzophenone: 0.02 part
Methylethylketone: 18 parts

The above liquid for photosensitive layer was coated on polyethylene terephthalate films, as a substrate, having a thickness of 12 μm with a bar coater, and the coated polyethylene terephthalate films were dried by subjecting them to irradiation under a infrared lamp (3 kw) for 20 seconds to prepare positive-type photosensitive layers. The resultant photosensitive layers had a dried coating thickness of 0.7 μm.

[Preparation of image-forming material]

Each of the above protection films on which the coloring agent-containing photosensitive layes were formed and each of the above substrates on which the photosensitive layer containing no coloring agent were formed were laminated at 30°C by bringing their photosensitive layers in contact, to obtain image-forming materials.

Each of the image-forming materials of four colors and a color separation positive film corresponding thereto were exactly registered with register pins, and they were exposed to light for 30 seconds (equivalent

9

to 100 mj/cm$^2$) by using a 1.5 kw ultrahigh pressure mercury lamp (made by Ushio Electric Co.).

Then, the polyethylene films as protection films were separated, and the photosensitive layer for balck and an art paper as an image receptor were contacted in the nip between rolls to carry out the transfer. Then, the substrate was separated and the post exposure was carried out. The same procedure was repeated with regard to the photosensitive layers for cyan, magenta and yellow in this order, to give a finish image similar all over to a usual printed matter obtained by a printing machine. The reproduced image, which was reproduced faithfully, had 50 lines/mm corresponding to the image on the color separation positive film.

It was observed that all the colored photosensitive layers and part of the non-colored photosensitive layers, equal to about nine tenths of the total amount of the photosensitive layers, had been transferred to the image receptor.

The solid density of the resultant transferred image was 2.0, measured by using a reflection densitometer (RD-918 made by Macbeth) using a neutral density filter.

In the above procedures, the feed rate was 50 cm/minutes, the nip pressure between the rolls was 4 kg/cm$^2$, and the temperatures were 48°C at the upper roll and 100°C at the lower roll. And, the diameter of each of the upper and lower rolls was 150 mm, the Shore hardness A of the upper roll was 70, and the lower roll was made of metal. The original sheet transferred had a width of 260 mm, and the distance while the image-receptor and the image-forming material were in contact was 10 mm.

Further, the above transferring procedure was repeated three times by using the same original image to form transferred images, and the resultant transferred images were compared with one another to show that these resultant images were uniform and indistinguishable from one another.

COMPARATIVE EXAMPLE 1

The procedure of Example 1 was repeated except that non-colored photosensitive layers were not used. That is, image-forming materials having colored photosensitive layers only were similarly sub3ected to image exposure, protection films were separated and brought into contact with an art papers to transfer the image.

About two thirds of the total amount of the colored photosensitive layers were transferred. The above procedure for image formation was repeated three times by using the photosensitive layers of the same type to show that the resultant images had different color densities. The resolving power was 50 lines/mm.

COMPARATIVE EXAMPLE 2

Comparative Example 1 was repeated except that the thickness (dried film thickness) of each of the colored photosensitive layers was changed to 6 µm, and the results were similar to those of Comparative Example 1. Stain was observed.

EXAMPLE 2

The same image-forming materials as those used in Example 1 were subjected to image exposure and their protection films were separated. By the use of a flat-bed proofing machine having a heating device on its paper-fixing bed, the image-forming material was fixed around a branket cylinder, and the branket cylinder was rotated such that an image receptor of art paper was contacted to the image-forming material to transfer an image to an image receptor under the conditions that the temperature was 100°C, the pressure was 4 kg/cm$^2$ and the transfer time was 1 minute. The above transfer was repeated by using each of the remaining image-forming materials and the image receptor in the same order of transfer as in Example 1.

The finish quality was nearly equal to a printed matter.

EXAMPLE 3

Example 1 was repeated except that the conditions of the transfer between rolls and the separation were changed as follows.

The feed rate was 40 cm/minute, the nip pressure was 2 kg/cm$^2$, the temperature of an upper roll was 50° C, and the temperature of a lower roll was 90° C.

Then, the results nearly identical to those of Example 1 were obtained.

## EXAMPLE 4

Example 1 was repeated except that the conditions of the transfer between rolls and the separation were changed as follows.

The feed rate was 60 cm/minute, the nip pressure between rolls was 4 kg/cm$^2$, the temperature of an upper roll was 50 °C, and the temperature of a lower roll was 120 °C.

Then, the results nearly identical to those of Example 1 were obtained.

## EXAMPLE 5

A liquid for a photosensitive layer composed of the following materials was prepared.

Polyester (Vylon 300, made by Toyobo Co., Ltd.) as a polymer, tetraethyleneglycol diacrylate (A-4EG, made by Shin Nakamura Chemical Co., Ltd.) and trimethylolpropane triacrylate (ATMPT, made by the latter company) as monomers, and 2-hydroxy-2-methyl-propiophenone (Darocur 1173, made by Merck Co., Ltd.) as a photopolymerization initiator.

Further, as pigments, the following were used in liquids for photosensitive layers.

Lionol Yellow FG1310 (made by Toyo Ink Manufacturing Co., Ltd) for yellow, Lionol Red 7BFG4412 (made by Toyo Ink Manufacturing Co., Ltd.) for magenta, Lionol Blue FG7330 (made by Toyo Ink Manufacturing Co., Ltd.) for cyan and Mitsubishi Carbon MA7 for black.

In order to dissolve the polymer in MEK (methylethylketone) in a polymer-to-solvent ratio of 20 parts to 47 parts, a mixture of these two components was subjected to a shaking in a warm bath for 48 hours, and a solution of dissolved polymer was obtained.

Then, the monomers of 1 part of A-4EG and 3 parts of ATMPT were mixed with the solution of dissolved polymer (20 parts without the solvent), and further 3 %, based on the entire solutes, of the above photopolymerization initiator was added to obtain a liquid for a photosensitive layer.

In order to incorporate pigments into the above-obtained liquid for a photosensitive layer, the shaking in a warm bath by a red devil was repeated five times. In general, it is preferable to add a solvent, etc., in order to maintain suitable fluidity.

As for color proofing material for printing, pigments were incorporated into the liquid for a photosensitive layer in amounts, based on the entire solids of the liquid, of 18 % for yellow, 18 % for magenta, 18 % for cyan and 9 % for black. After the photosensitive materials were milled by a red devil, the photosensitive materials were coated on polyethlene films (40 μm thick) respectively, and the coated films were subjected to irradiation by an infrared lamp (3KW) for 30 seconds and dried to give positive-type colored light sensitive layers. The thickness (dried) each of the coatings (films) was 2 μm.

Photosensitive layers containing no coloring agent were prepared in the same way as in Example 1, and image-forming materials were prepared in the same way as in Example 1.

The photosensitive layers of four colors were subjected to image exposure in the same way as in Example 1, and the polyethylene terephthalate films were detached. A wood free paper and the photosensitive layer were brought into contact in the nip between rolls in the same way as in Example 1 to carry out the transfer. The substrate was detached and the post exposure was carried out to form an image.

There was obtained a reproduced image of 40 lines/mm fidelity corresponding to an image on the color separation positive film. In the above procedure in this Example, about nine tenths of the entire photosensitive layer was transferred.

Thereafter, the same procedure was carried out with regard to the remaining three colors in the order of yellow, magenta, cyan and black, and an image each was formed on the same image receptor to give an image having texture very similar to a usual printed matter.

## EXAMPLE 6

A photosensitive layer containing the same coloring agent as used in Example 1 was formed on a polyethylene film in the same way as in Example 1 such that the dried thickness of the coated film was 2

μm. Further, a liquid for a photosensitive layer containing Lionol Blue FG7330 in place of carbon balck used in the above photosenstive layer was coated on a polyethylene terephthalate film such that the dried thickness was 2 μm. The photosensitive layers of the above two films were brought into contact with each other in the same way as in Example 1 to obtain a positive type image-forming material. The image exposure and transfer were carried out in the same way as in Example 1 to form an image.

The resultant image was of somewhat bluish black, however, showed a finish quality similar to a usual printed matter. It was a reproduced image having a 50 lines/mm fidelity corresponding to the image on a color separation positive film.

EXAMPLES 7 - 8

Example 1 was repeated except the use of the following two electric conductivity-imparting materials as an electrical conductivity-imparted substrate, to form image-forming materials and form images. As a result, good images were obtained without causing any problem due to static electricity.

(Example 7)

| Elecrostripper QN (made by Kao K.K.): | 1 part |
| Toluene: | 49 parts |
| Xylene: | 50 parts |

The above materials were dissolved mutually by stirring with a disper, and the resultant electrical conductivity-imparting liquid was coated on one surface of a polyethylene terephthalate film (having a thickness of 12 μm) such that the thickness of the dried coating was 2 μm. In addition, a photosensitive layer was formed on the other surface of the substrate opposite to the surface coated with the electrical conductibity-imparting material.

(Example 8)

A polyethylene terephthalate film (Q-21, made by Toray Co., Ltd.), which contains electrically conducting substance, was used.

The surface electric resistances of the films in Examples 7 and 8 were $6 \times 10^8$ and $5 \times 10^9$ Ω, respectively.

EXAMPLE 9

[Photosensitive layer containing coloring agent]

A liuid for a photosensitive layer composed of the following materials was prepared.
Diallylisophthalate prepolymer: 14.34 parts
Dipentaerythritolhexaacrylate DPHA : 6.14 parts
Benzophenone: 2.58 parts
4,4' bis-diethylaminobenzophenone (EAB): 1.03 parts
p-Methoxyphenol: 0.1 part
Carbon black MA-7: 2.89 parts
Alkali blue toner (Reflex Blue R-52 made by Hoechst Japan K.K.): 0.73 part
Toluene: 40.0 parts
Methylethyleketone: 30.0 parts
In addition, in place of the above carbon black as a pigment, Lionol Yellow FG1310 for yellow, Lionol Red 7BFG4412 for magenta and Lionol Blue FG7330 for cyan (all manufactured by Toyo Ink Manufacturing Co., Ltd.) were respectively used to prepare liquids for photosensitive layers for yellow, magenta and cyan. The ratios of the above pigments used in the photosensitive layers were 18% for yellow, 18% for magenta and 18% for cyan.

The above liquids for photosensitive layers were coated on polyethylene films, protection films, having a film thickness of 40 μm by using a bar coater such that the thickness each of the dried coatings was 1.5 μm, and the coated polyethylene films were dried to prepare positive-type photosensitive layers.

[Photosensitive layer nearest to substrate containing coloring agent]

A liquid for a photosensitive layer having the following formulation was prepared.

Diallylorthophthalate prepolymer(Daiso DAP K, Osaka Soda Co., Ltd.,): 12.0 parts
Pentaerythritoltriacylate: 8.0 parts
Benzophenone: 1.0 part
4,4' bis-diethylaminobenzophenone: 0.2 part
Carbon black: 0.5 part
p-Methoxyphenol: 0.1 part
Methylethylketone: 80.0 parts

The above liquid for photosenstive layer was coated on polyethylene terephthalate films, as a substrate, having a thickness of 12 μm with a bar coater, and the coated polyethylene terephthalate films were dried to prepare positive-type photosensitive layers. The resultant photosensitive layers had a dried coating thickness of 0.7 μm.

[Preparation of image-forming material]

Each of the above protection films on which the coloring agent-containing photosensitive layes were formed and each of the above substrates on which the photosensitive layer containing no coloring agent and being capable of causing a breakaway within the layer were formed were laminated at 30°C by bringing their photosensitive layers in contact, to obtain image-forming materials.

The image exposure was carried out in the same way as in Example 1 and the transfer to an art paper was carried out. The post exposure was also carried out to give a finish quality quite equal to a usual printed matter (printed by a printing machine). The faithfully reproduced image had 50 lines/mm corresponding to the image on the color separation positive film.

It was observed that about nine tenths of the total of the colored photosensitive layers had been transferred to the image receptor.

The solid density of the resultant transferred image was 2.0. Image-forming materials prepared in the same way as in the above were used to form images three times, and the resultant images were compared to show that the images were uniform and the solid densities were always 2.0.

EXAMPLE 10

Hexahydrorthophthalic acid and allyl alcohol were allowed to react with each other in an autoclave in the presence of triethylamine at 130°C for 5 hours, and dehydrated to give a diallyl hydrous orthophthalate monomer. The diallyl hydrous orthphthalate monomer was polymerized at 170°C by adding benzoyl peroxide and dibutyltinlaurate as a catalyst to give a prepolymer having a weight average molecular weight of 10,000.

| | |
|---|---|
| The above dially hydrous orthopthalate prepolymer: | 14.34 parts |
| Pentaerythritoltriacrylate: | 6.14 parts |
| 2,4,6-Trimethylbenzophenone: | 1.00 part |
| 4,4' bis-diethylaminobenzohpenone: | 0.40 part |
| p-Methoxyphenol: | 0.05 part |
| Oil Black #HBB (manufactured by Orient Chemical Kogyo K.K.): | 1.00 part |
| Toluene: | 40.00 parts |
| Methylethylketone: | 30.00 parts |

The above components were used to prepare a liquid for a photosensitive layer. This liquid was coated on a polyethylene terephthalate film as a substrate such that the thickness of dried coating was 0.7 µm. Separately, the same liquid for coloring photosensitive layer as that used in Example 1 was coated on a polyethylene film as a protection film such that the thickness of the dried coating was 1.5 µm. Then, the photosensitive layer side of the polyethylene terephthalate film and the photosensitive layer side of the polyethylene film were brought intimately contact with each other at 30°C to give an image-forming material.

The image exposure and transfer to an art paper were carried out in the same way as in Example 1 and the postexposure was carried out to give a finish quality identical with that of a usual printed matter (by a printing machine). The amount of exposure necessary for this image-forming material was one third of that necessary for the image-forming material obtained in Example, and the amount of postexposure necessary for this image-forming material was half of that in Example 1. It is thought that the above results was brought by an increase in the curing speed of the photosensitive layer in which the breakaway separation took place.

The photosensitive layers in a volume corresponding to nine tenths of the total thereof were transferred to the image receptor.

The solid density of the resultant image was 2.0. Separately, image-forming materials were prepared in the same way as in the above procedure and images were formed three times in the same way as above. Comparison of these resultant three images showed uniformity, a constant solid density of 2.0 and stability.

EXAMPLE 11

A liquid for a photosensitive layer composed of the following formulation was prepared and coated on the image-forming material obtained in Example 1 such that the coating was adjacent to the protection film and had a thickness of 0.5 µm, i.e., an image-forming material having three photosensitive layers were obtained.

[Photosensitive layer]

| | |
|---|---|
| Polyethylene glycol (PEG-6000, manufactured by Wako Junyaku K.K., weight average molecular weight: 7,500): | 6.5 parts |
| Tris(2-acrylyloyloxyethyl)isocyanurate (Aronix M-315,manufactured by Toa Gosei K.K.): | 2.5 parts |
| 1,6-Hexanedioldiacrylate (Ester A-HD, manufactured by Shin Nakamura Chemical Co., Ltd.): | 1.5 parts |
| 1-(4-Dodecylphenyl)-2-hydroxy-2-methylpropan-1-one (Darcur 953, manufactured by Merck Japan K.K.): | 0.08 part |
| Methylethylketone | 30.0 parts |
| Isopropyl alcohol | 40.0 parts |
| Toluene | 13.5 parts |

The above components were dissolved mutually by stirring with a disper for 30 minutes to prepare a liquid for a photosensitive layer. This liquid was coated on a polyethylene film as a protection film such that the dried coating thickness was 0.5 µm. And the photosensitive layer of this protection film and the photosensitive layer of the same image-forming material having two photosensitive layers as that obtained in Example 1 (without its protection film) were laminated by bringing them into contact with each other at 30°C to obtain an image-forming material.

The image exposure was carried out in the same way as in Example 1 and the transfer was carried out by using a wood free paper and a news paper as an iamge receptor. The resultant images were as good as those obtained by using an art paper.

Table 1

|  | Picking | Stain | Ressolving power (line/mm) | Solid density | Transfer stability |
|---|---|---|---|---|---|
| Ex. 1 | No | No | 50 | 2.0 | good |
| Ex. 2 | No | No | 50 | 2.0 | good |
| Ex. 5 | some extent | No | 40 | 2.2 | good to ordinary |
| Ex. 6 | No | No | 50 | 2.0 | good |
| Ex. 9 | No | No | 50 | 2.0 | good |
| Ex. 9 (cyan) | No | No | 50 | 1.7 | good |
| Ex. 10 | No | No | 50 | 2.0 | good |
| CEx. 1 | Yes | No | 50(*1) | 1.3 | poor |
| CEx. 2 | No | Yes | - (*2) | 2.2 | poor |

(*1) Picking occurred. Resolving power and solid density were measured by using measurable places.

(*2) Stain was observed to a considerable extent. Resolving power was not measured.

The solid densities were measured by using a reflection densito-meter RD-918 (ND filter) made by Macbeth. As for measurement for cyan, a RED filter was used.

It is observed from the results shown in the above Table that the effect of breakaway within the layer nearest to the substrate on the transfer beings improvement in density of the transferred images, and it was made possible to give a texture very much similar to that of an actual printed matter obtained by using a printing machine. Said breakaway also contributes to the desnity stability since all the photosensitive layers except one positioned next to the substrate can be transferred.

Furthermore, in the formation of images in Examples, the film thicknesses of the transferred images on the image receptors were almost uniform, uniform film thicknesses could be obtained even when the transfer was repeated, and the surface forms were nearly identical with those obtained by using printing ink.

Meanwhile, in the formation of iamges in Comparative Examples, the film thickness was observed to vary from 1.0 to 1.6 μm, and the surface forms were also different to some extent from those obtained by using printing ink.

Therefore, when the present invention is used as a color proofing material, etc., a texture very similar to that of a usual printed matter can be obtained, and a conventional trouble due to differences in textrue can be avoided. The surface form was determined by using 195-power microphotographs.

In Comparative Example 1, the existence of mottlig was observed, and therefore the obtained image quality was poor as compared with the resolving power shown by lines/mm.

Furthermore, the softening points of the image-forming materials obtained in the foregoing Examples were measured by the following method.

[Method for measurement of softening point of image-forming material]

With regard to each of the photosensitive layers obtained in Examples and summarised in Table 2, one layer threof was provided onto a polyethylene terephthalate film and bonded thereto without carrying out the exposure but by subjecting them to heat sealing at 80°C for which a special laminator (8B-700, made by Taisei Laminator K.K.) was used. These bonded laminates were cut to a width of 25 mm to prepare samples.

The image receptor sides of the above samples were arranged to be flat, and breakaway strengths between the image receptors and the surfaces of the polyethylene terephthalte films at 180 degrees were measured by using a Tensilon UTM-III tensile tester (made by Toyo Boldwin K.K.). The breakaway speed was 50 cm/minute, and the samples had a width of 25 mm and a lenght of 10 cm.

TABLE 2

|  | Breakaway strength (g/25mm) | Occurrence of picking | Temperature (°C) |
|---|---|---|---|
| Photosensitive layer with coloring agent in Example 1 | 5.0 | No | 90 |
| Same as avove | 8.0 | Yes | 60 |
| Photosensitive layer without coloring agent in Example 1 | 3.0 | No | 60 |
| Same as above | 7.0 | Yes | 40 |
| Photosensitive layer with coloring agent in Example 7 | 4.5 | No | 90 |
| Same as above | 7.2 | Yes | 60 |
| Photosensitive layer without coloring agent in Example 7 | 3.0 | No | 60 |
| Same as above | 7.0 | Yes | 40 |
| Photosensitive layer with coloring agent in Example 8 | 4.0 | No | 90 |
| Same as above | 7.0 | Yes | 60 |
| Photosensitive layer without coloring agent in Example 8 | 3.0 | No | 40 |
| Same as above | 5.0 | Yes | 25 |

The data in the above Table shows that when the image-forming material is composed of a plurality of layers, a layer having a low breakaway strength first undergoes the selective breakaway separation.


## Claims

1. An image-forming material suitable for use in an image transfer process which comprises a substrate and a photosensitive layer, optionally having a protective film, the photosensitive layer comprising a dye or pigment and a photopolymerizable compound, wherein the photosensitive layer comprises two or more layers, the dye or pigment being contained in at least one of those layers but being absent from the layer in direct contact with the substrate, the image forming material being such that upon imagewise exposure the exposed areas and unexposed areas differ in their adhesion to a receptor and image transfer occurs through a breakaway separator within the layer in direct contact with the substrate.

2. An image-forming material according to Claim 1 wherein the layer in direct contact with the substrate is formed of a material having the lowest softening point of all the constituent materials of the photosensitive layer.

3. An image-forming material according to Claim 1 or 2 wherein the layer in direct contact with the substrate comprises a hydrogenated diallylphthalate resin and an ethylenically unsaturated compound.

4. An image-forming material according to any one of the preceding claims wherein the photosensitive layer comprises three layers and the layer which is third from the substrate contains no dye or pigment.

5. An image-forming material according to any one of the preceding claims wherein the substrate is permeable to light or conducts electricity.

6. An image-forming material according to any one of the preceding claims wherein the photosensitive layer comprises an organic polymer binder having no photopolymerization property, such as a thermoplastic resin or a diallylphthalate resin.

7. An image-forming material according to Claim 6 wherein the photopolymerizable compound in the photosensitive layer is an ethylenically unsaturated compound, the organic binder is a thermoplastic resin and the weight ratio of the thermoplastic resin to the ethylenically unsaturated compound is from 40:60 to 90:10.

8. An image-forming material according to any one of the preceding claims wherein the proportion of the dye or pigment contained in the layer in direct contact with the substrate is from 0 to 10% by weight of the solids content of that layer, and the proportion of dye or pigment contained in the remaining layers is from 5 to 50% by weight of the total weight of the solids content of those layers.

9. An image-forming material according to any one of the preceding claims wherein the total thickness of the photosensitive layer comprising two or more layers is from 0.5 to 5.0 μm.

10. An image-forming material according to Claim 1 which is formed by bringing that layer of the photosensitive layer which is positioned next to the substrate into contact with the dried top layer of the photosensitive layer coated on the protection film.

11. Use of an image-forming material as claimed in any one of the preceding claims in an image transfer process.